# EUROPÄISCHE PATENTSCHRIFT

(11) **EP 0 871 069 B1**
(45) Veröffentlichungstag und Bekanntmachung des Hinweises auf die Patenterteilung: **04.12.2002**
(21) Anmeldenummer: 98106451.2
(22) Anmeldetag: 08.04.1998
(51) Int. Cl.: G03F 7/033

(54) **Lichtempfindliches Gemisch und daraus hergestelltes Aufzeichnungsmaterial**
Light-sensitive mixture and recording material prepared therefrom
Mélange photosensible et matériau d'enregistrement préparé avec ce mélange

(30) Priorität: 11.04.1997 DE 19715169
(43) Veröffentlichungstag der Anmeldung: 14.10.1998
(73) Patentinhaber: BASF Drucksysteme GmbH, 70469 Stuttgart (DE)
(72) Erfinder: Telser, Thomas, Dr., 69469 Weinheim (DE); Wegener, Stefan, Dr., 55124 Mainz (DE); Philipp, Sabine, Dr., 64546 Mörfelden-Walldorf (DE); Sandig, Hartmut, Dr., 67227 Frankenthal (DE)
(74) Vertreter: Isenbruck, Günter, Dr.

(56) Entgegenhaltungen:
- EP-A- 0 326 977
- DATABASE WPI Section Ch, Week 8804 Derwent Publications Ltd., London, GB; Class A89, AN 88-025851 XP002071963 & JP 62 287 234 A (NIPPON PAINT CO LTD)
- PATENT ABSTRACTS OF JAPAN vol. 097, no. 007, 31.Juli 1997 & JP 09 087591 A (NIPPON ZEON CO LTD), 31.März 1997,

## Beschreibung

Die Erfindung betrifft ein lichtempfindliches, insbesondere photopolymerisierbares Gemisch sowie ein daraus hergestelltes Aufzeichnungsmaterial, das zur Herstellung von Reliefdruckplatten, vor allem für den Flexodruck geeignet ist.

Aufzeichnungsmaterialien der genannten Gattung weisen im allgemeinen eine photopolymerisierbare Schicht auf, die ein polymeres Bindemittel, eine polymerisierbare Verbindung, einen Photopolymerisationsinitiator und gegebenenfalls weitere übliche Bestandteile enthält.

Für die Herstellung von Flexodruckplatten werden zumeist elastomere Bindemittel wie Block-Copolymere, zum Beispiel Dreiblock-Copolymere mit Styrol-Isopren-Styrol-Blöcken oder Styrol-Butadien-Styrol-Blöcken bevorzugt, wie sie zum Beispiel in der DE-A 22 15 090 beschrieben sind. Die Dreiblock-Copolymeren können als einzige Elastomere oder in Kombination mit Zweiblock-Copolymeren, zum Beispiel Styrol-Isopren- oder Styrol-Butadien-Zweiblock-Copolymeren, eingesetzt werden. Herstellungsbedingt liegt meist eine Mischung aus Dreiblock-Copolymeren und Zweiblock-Copolymeren vor.

Dreiblock-Copolymere aus Styrol-Isopren-Styrol/Butadien, bei denen der dritte Block statistisch aus Styrol- und Butadieneinheiten aufgebaut ist, werden in der EP-A 0 027 612 beschrieben.

Druckplatten, die diese Elastomeren als Bindemittel enthalten, sind weich und elastisch und können deshalb sehr gut im Flexodruck eingesetzt werden. Sie sind beständig gegenüber Druckfarben auf Basis von Wasser oder Alkoholen als Lösemittel. Auflagenhöhen von mehr als 1 Million werden erreicht.

Derartige Druckplatten sind jedoch weniger geeignet, wenn durch UV-Licht härtbare Druckfarben oder Druckfarben auf Basis von Ester enthaltenden Alkoholen als Lösemittel verdruckt werden sollen. Ester wie Ethylacetat oder Propylacetat werden Druckfarben auf Alkoholbasis häufig zugesetzt, um eine schnellere Trockung der Farbe zu erreichen oder um eine bessere Benetzung von kritischen Bedruckstoffen, wie Polyester-, Polyvinylchlorid- oder Aluminiumfolien, zu bewirken. Durch UV-Licht härtbare Druckfarben werden in neuerer Zeit vermehrt eingesetzt, das sich hiermit eine bessere Druckqualität erreichen läßt. Hierbei kommen radikalisch härtbare oder kationisch vernetzbare Druckfarben zu Einsatz.

In der EP-A 0 326 977 werden lichtempfindliche Aufzeichnungsmaterialien für die Herstellung von Flexodruckplatten beschrieben, die als Bindemittel Terpolymere aus statistisch verteilten Ethylen-, Propylen- und Alkadieneinheiten enthalten. Aufgrund der geringen Polarität dieser Bindemittel weisen die dort beschriebenen Flexodruckplatten zwar eine höhere Quellbeständigkeit gegenüber Esterlösemittel enthaltenden Druckfarben auf; ihre Oberfläche ist jedoch zu klebrig und ihr Auflösungsvermögen niedrig. Der Einsatzbereich dieser Flexodruckplatten wird dadurch stark eingeschränkt.

Aufgabe der Erfindung war es, lichtempfindliche Aufzeichnungsmaterialien für die Herstellung von Relief-, insbesondere Flexodruckplatten vorzuschlagen, die eine bessere Quellbeständigkeit gegenüber durch UV-Licht härtbaren Druckfarben und Esterlösemittel enthaltenden Druckfarben auf Alkoholbasis aufweisen und zugleich das Auflösungsvermögen der besten gegenwärtig bekannten Flexodruckplatten auf Basis von Bindemitteln aus Styrol-Isopren-Styrol- oder Styrol-Butadien-Styrol-Dreiblock-Copolymeren erreichen.

Erfindungsgemäß wird ein lichtempfindliches Gemisch vorgeschlagen, das
A) ein elastomeres Block-Copolymeres als Bindemittel,
B) eine polymerisierbare Verbindung und
C) eine Verbindung enthält, wie unter Einwirkung aktinischer Strahlung die Polymerisation der Verbindung B zu initieren vermag.

Das erfindungsgemäße Gemisch ist dadurch gekennzeichnet, daß das elastomere Block-Copolymere A ein Copolymeres mit Blöcken aus polymerisierten
1. Styroleinheiten
2. Ethylen- und 1,2-Butyleneinheiten als Alkyleneinheiten und
3. Isopreneinheiten als Dieneinheiten ist.

Erfindungsgemäß wird auch ein lichtempfindliches Aufzeichnungsmaterial mit einem dimensionsbeständigen Schichtträger und einer darauf aufgebrachten lichtempfindlichen, insbesondere photopolymerisierbaren Schicht vorgeschlagen, das dadurch gekennzeichnet ist, daß die lichtempfindliche Schicht aus einem Gemisch der vorstehend angegebenen Zusammensetzung besteht.

Die Blöcke aus Alkyleneinheiten sind herstellbar durch Hydrierung von vorgefertigten Blöcken von Polybutadien. Die Hydrierung läßt sich an den fertigen Blockcopolymeren mit Blöcken aus Styroleinheiten, Isopreneinheiten und Butadieneinheiten elegant durchführen, indem die Butadienblöcke selektiv hydriert werden. Dabei erfolgt die Hydrierung der Butadieneinheiten nahezu quantitativ, während die Isopreneinheiten praktisch unverändert bleiben. Bei der Hydrierung entstehen in Abhängigkeit davon, ob die Butadieneinheiten im Polymeren durch 1,2- oder 1,4-Addition gebildet worden sind, Ethylen- oder 1,2-Butyleneinheiten. Das ursprüngliche Block-Copolymere aus Styrol-, Butadien- und Isoprenblöcken kann durch Verknüpfen von vorgefertigten Isoprenblöcken mit vorgefertigten Block-Copolymeren aus einem Styrol- und einem Butadienblock mittels geeigneter mehrfunktioneller Kupplungsagentien, zum Beispiel Polyhalogenalkane, hergestellt werden. So können zum Beispiel jeweils 2 Isoprenblöcke mit jeweils zwei Styrol-Butadien-Blockcopolymeren über ein zentrales tetrafunktionelles Kupplungsagens zu einem Stern-Blockcopolymeren verknüpft werden. Die Herstellung derartiger Polymerer ist bekannt, und entsprechende Produkte sind im Handel erhältlich.

Die besondere Resistenz der aus den erfindungsgemäßen Gemischen beziehungsweise Aufzeichnungsmaterialien hergestellten Druckformen gegenüber Druckfarben, die Ester als Lösemittelbestandteile oder flüssige ungesättigte durch UV-Strahlung härtbare Bestandteile enthalten, ist vermutlich auf die in den Gemischen enthaltenen speziellen Bindemittel mit einer Kombination von Hartphasen (Polystyrolblöcke) mit unterschiedlichen Weichphasen (Polydien- und Polyolefinblöcke) zurückzuführen.

Die Gemische enthalten im allgemeinen 50 bis 95, vorzugsweise 70 bis 95 Gew.-% Bindemittel A, bezogen auf die Gesamtmenge von Bindemitteln und polymerisierbaren Verbindungen.

Die erfindungsgemäßen Gemische enthalten weiterhin in bekannter Weise polymerisierbare Verbindungen beziehungsweise Monomere B. Die Monomeren sollen mit dem Bindemittel verträglich sein und mindestens eine polymerisierbare ethylenische Doppelbindung aufweisen: geeignete Monomere haben im allgemeinen einen Siedepunkt von mehr als 100°C bei Atmmosphärendruck und ein Molekulargewicht bis zu 3000, vorzugsweise bis zu 2000. Als besonders vorteilhaft haben sich Ester oder Amide der Acryl- oder Methacrylsäure, Styrol oder substituierte Styrole, Ester der Fumar- oder Maleinsäure oder Allylverbindungen erwiesen. Geeignete Monomere sind in der EP-A 0 326 977 genannt. Der Gehalt der Gemische an polymerisierbaren Monomeren B liegt im allgemeinen im Bereich von 5 bis 50, vorzugsweise 5 bis 30 Gew.-%, bezogen auf die Gesamtmenge von Bindemittel A und Monomeren B.

Als Initiatoren C für die Photopolymerisation sind unter anderen Benzoin oder Benzoinderivate, wie α-Methylbenzoin oder Benzoinether, Benzilderivate, wie Benzilketale, Acylarylphosphinoxide, Acylarylphosphinsäureester oder -natriumsalze, Mehrkernchinone oder Benzophenone geeignet. Das Gemisch enthält im allgemeinen 0,1 bis 5 Gew.-% an Photoinitiatoren, bezogen auf die Menge von A + B.

Die erfindungsgemäßen Gemische können ferner übliche Hilfsstoffe enthalten, vor allem Weichmacher, Inhibitoren für die thermisch initiierte Polymerisation, Farbstoffe, Pigmente, photochrome Zusätze, Mittel zur Verbesserung der Reliefstruktur, Vernetzungshilfsmittel, Antioxidantien, Antiozonantien, Füllstoffe, Flußmittel oder Formtrennmittel. Ihre Menge soll 40 Gew.-% des gesamten Gemischs nicht überschreiten.

Beispiele für Weichmacher sind modifizierte und unmodifizierte Naturöle und -harze, Alkyl-, Alkenyl-, Arylalkyl- oder Arylalkenylester von Säuren, wie Alkansäuren, Arylcarbonsäuren oder Phosphorsäure; synthetische Oligomere oder Harze wie Oligostyrol, oligomere Styrol-Butadien-Copolymere, oligomere α-Methylstyrol/p-Methylstyrol-Copolymere, flüssige Oligobutadiene, oder flüssige oligomere Acrylnitril-Butadien-Copolymere; sowie Polyterpene, Polyacrylate, Polyester oder Polyurethane, Polyethylen, Ethylen-Propylen-Dien-Kautschuke oder ω-Methyl-Oligo(ethylenoxid).

Beispiele besonders gut geeigneter Weichmacher sind paraffinische Mineralöle; Ester von Dicarbonsäuren wie Dioctyladipat oder Terephthalsäuredioctylester; naphthenische Weichmacher oder Polybutadiene mit einem Molgewicht zwischen 500 und 5000. Von Vorteil sind Mengen von 5 bis 50 Gew.-%, bezogen auf das Gewicht des gesamten Gemischs.

Inhibitoren für die thermisch initiierte Polymerisation werden im allgemeinen in einer Menge von 0,001 bis 2 Gew.-% bezogen auf die gleiche Größe wie vorstehend zugesetzt. Beispiele sind Hydrochinon, p-Methoxyphenol, 2,6-Di-tert.-butyl-p-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine.

Farbstoffe, Pigmente oder photochrome Zusätze können in einer Menge von 0,0001 bis 2 Gew.-% zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist es, daß sie - ebenso wie die Inhibitoren - die Photopolymerisation der Gemische nicht stören. Geeignet sind zum Beispiel die löslichen Phenazinium-, Phenoxazinium-, Acridinium- und Phenothiaziniumfarbstoffe. Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milder Reduktionsmittel sind Ascorbinsäure, Anethol, N-Allylthioharnstoff, sowie Salze des N-Nitroso-cyclohexylhydroxylamins. Letztere können, wie erwähnt, zugleich als Inhibitoren der thermisch initiierten Polymerisation dienen.

Die Reduktionsmittel werden im allgemeinen in Mengen von 0,005 bis 5 Gew.-% zugesetzt, wobei sich in vielen Fällen der Zusatz des 3- bis 10fachen der Menge an Farbstoff bewährt hat.

Beispiele für Vernetzungshilfsmittel sind tri- und tetrafunktionelle Thiolverbindungen.

Beispiele für Antioxidanten sind sterisch gehinderte Monophenole, wie 2,6-Di-tert.-butyl-p-kresol; alkylierte Thiobis- und Alkylidenbisphenole; Hydroxybenzyle, wie 1,3,5-Trimethyl-2,4,6-tris-(3,5-di-tert.-butyl-4-hydroxybenzyl)benzol; Triazine; Zinkbutyldithiocarbamat; Dilaurylthiodipropionat; oder Phosphite, wie Tris(nonylphenyl)phosphit. Von Vorteil sind Mengen von 0,0001 bis 5 Gew.-%.

Beispiele für polymere oder nicht polymere organische und anorganische Füllstoffe oder Verstärkungsfüllstoffe sind solche, die für die Wellenlängen des zur Belichtung der erfindungsgemäßen Aufzeichnungsmaterialien verwendeten Lichts im wesentlichen durchlässig sind, dieses Licht nicht streuen und in ihrem Brechungsindex weitgehend dem betreffenden erfindungsgemäßen Gemisch angepaßt sind, wie etwa Polystyrol, organophiles Siliciumdioxid, Bentonit, Kieselsäure, organophiles Aluminiumoxid, Glaspulver, kolloidaler Kohlenstoff sowie andere Pigmente.

Ein Beispiel für ein Flußmittel ist Calciumstearat. Ein Beispiel für ein Formtrennmittel is Talkum. Beispiele für Antiozonantien sind die üblichen und bekannten Ozonschutzwachse sowie die Chloralkane mit 8 bis 40 Kohlenstoffatomen und 30 bis 73 Gew.-% Chlor im Molekül.

Beispiele für Mittel zur Verbesserung der Reliefstruktur der aus den erfindungsgemäßen Aufzeichnungsmaterialien hergestellten Reliefdruckplatten sind beispielsweise 9,9'-Dianthronyl und 10,10'-Bisanthron.

Die Dicke der photopolymerisierbaren reliefbildenden Schicht richtet sich in erster Linie nach dem Verwendungszweck der erfindungsgemäßen Aufzeichnungsmaterialien. So variiert die Dicke im allgemeinen von 0,001 bis 7, vorzugsweise 0,1 bis 7 und insbesondere 0,7 bis 6,5 mm, weil die erfindungsgemäßen Aufzeichnungsmaterialien für verschiedene Drucktechniken geeignet sind.

Außer der photopolymerisierbaren Schicht kann das erfindungsgemäße Aufzeichnungsmaterial weitere Schichten oder flächenförmige Gebilde enthalten, welche für seine Funktion von Nutzen sind.

So kann die photopolymerisierbare Schicht mit dem dimensionsstabilen Schichtträger haftfest oder leicht ablösbar verbunden sein. Der Schichtträger wiederum kann mit einer weichelastischen Unterschicht unterlegt sein. Ferner kann eine haftfeste Verbindung zwischen dem Schichtträger und der Photopolymerschicht mit Hilfe einer Haftschicht erreicht werden. Sofern der Träger mit der Photopolymerschicht leicht ablösbar verbunden ist, wird er auch als temporärer Schichtträger bezeichnet.

Als dimensionsstabile Träger können Platten, Folien oder konische oder zylindrischen Röhren (sleeves) aus Metallen, wie Stahl, Aluminium, Kupfer oder Nickel oder aus Kunststoffen, wie Polyethylenterephthalat, Polyamid oder Polycarbonat verwendet werden. Daneben kommen noch Gewebe und Vliese, wie Glasfasergewebe oder Verbundmaterialien aus Glasfasern und Kunststoffen in Frage.

Als Haftschichten werden mit Vorteil übliche und bekannte, etwa 0,5 bis 40 µm dicke Haftlackschichten verwendet.

Werden als Träger stark reflektierende Platten oder Folien verwendet, dann können sie geeignete Lichthofschutzmittel, wie Ruß oder Mangandioxid enthalten. Die Lichthofschutzmittel können aber auch als separate Schicht auf den Träger aufgetragen werden oder in der Haftschicht oder in der Photopolymerschicht enthalten sein.

Außerdem kann das erfindungsgemäße Aufzeichnungsmaterial eine lichtdurchlässige, in den Entwicklern für die Photopolymerschicht lösliche oder quellbare, glatte oder mattierte, nicht klebrige Deckschicht enthalten, welche an der Photopolymerschicht fester haftet als an einer gegebenenfalls vorhandenen Deckfolie und welche von einem reißfeste Filme bildenden Polymeren und den gegebenenfalls darin enthaltenen Zusatzstoffen gebildet wird.

Beispiele geeigneter, reißfester Filme bildender Polymerer sind Polyamide, voll- oder teilverseifte Polyvinylacetate oder Polyethylenoxid/Vinylacetat-Pfropfpolymerisate, Copolyamide, Polyurethane, Poly(meth)acrylate, Polyvinylalkohol-alkancarbonsäureester eines Hydrolysegrades von 30 bis 99%, Cyclokautschuke hohen Cyclisierungsgrads, Ethylen/Propylen-Copolymerisate, Homo- und Copolymerisate des Vinylchlorids oder Ethylen/Vinylacetat-Copolymerisate. Beispiele geeigneter Deckschichten, welche Zusatzstoffe enthalten, sind aus der US-A 4 162 919, der DE-A 28 23 300, der DE-B 21 23 702, der USA 4 072 527, der US-A 3 453 311 oder der DE-A 37 32 527 bekannt.

Im allgemeinen sind die Deckschichten 0,2 bis 25 µm dick.

Des Weiteren kann das erfindungsgemäße Aufzeichnungsmaterial eine Deckfolie enthalten, welche sich von der photopolymerisierbaren Schicht oder von der Deckschicht leicht ablösen läßt.

Die Deckfolien sind 10 bis 250, insbesondere 20 bis 150 µm dick. Sie bestehen im wesentlichen aus Kunststoffen, textilen Stoffen, Papieren oder Metallen. Diejenige Oberfläche der Deckfolie, welche der Deckschicht unmittelbar aufliegt, ist glatt, das heißt, sie weist einen Oberflächenrauhwert Rₘₐₓ ≤ 0,1 µm auf, oder sie ist mattiert, das heißt, sie hat einen Oberflächenrauhwert Rₘₐₓ zwischen 0,1 und 15, vorzugsweise 0,3 bis 10, und insbesondere 0,5 bis 7 µm. Sofern die Deckfolie mattiert ist, prägt sich ihr Rauhheitsmuster in die Deckschicht und gegebenenfalls auch noch in die photopolymerisierbare Schicht ein. Diese glatte oder matte Oberfläche der Deckfolie kann außerdem anithaftend ausgerüstet sein, das heißt, sie kann beispielsweise eine 0,1 bis 0,5 µm dicke Antihaftschicht aus Silikonen oder aus anderen Kunststoffen, wie etwa Polyethylen oder Polypropylen aufweisen.

Beispiele besonders vorteilhafter Deckfolien sind 20 bis 150 µm dicke, glatte oder mattierte, biaxial gereckte, gegebenenfalls antihaftend ausgerüstete Kunststofffolien aus Polyethylenterephthalat.

In allen Fällen kann die photopolymerisierbare Schicht aus photopolymerisierbaren Teilschichten aufgebaut werden. Diese Teilschichten können von gleicher, in etwa gleicher oder von unterschiedlicher stofflicher Zusammensetzung sein. Die Herstellung der aus Teilschichten aufgebauten Schicht kann nach der in der EP-A 0 084 851 angegebenen Methode erfolgen.

Die besonderen Vorteile der erfindungsgemäßen Aufzeichnungsmaterialien treten bei ihrer Verwendung für die Herstellung von Reliefdruckplatten, insbesondere von Flexodruckplatten, in überzeugender Weise zu Tage. Dabei umfaßt die Herstellung der Reliefdruckplatten aus den erfindungsgemäßen Aufzeichnungsmaterialien üblicherweise die folgenden Arbeitsgänge:
a) gegebenenfalls Vorbehandeln der erfindungsgemäßen Aufzeichnungsmaterialien,
b) gegebenenfalls Ablösen der Deckfolie von der gegebenenfalls vorhandenen Deckschicht,
c) Auflegen einer Bildmaske oder Negativvorlage,
d) bildmäßiges Belichten der photopolymerisierbaren Schicht mit aktinischem Licht einer Wellenlänge zwischen 230 und 450, insbesondere 350 und 450 mn,
e) Auswaschen (Entwickeln) der unbelichteten Bereiche der bildmäßig belichteten Schicht mittels geeigneter Entwickler, wobei auch die gegebenenfalls vorhandene Deckschicht weggewaschen wird,
f) Trocknen
g) gegebenenfalls Nachbehandeln der in dieser Weise erhaltenen Reliefdruckplatten, welche nun die Reliefschicht enthalten, oder aus dieser bestehen.

Die Dicke der Reliefschicht variiert je nach Anwendungszweck der Reliefdruckplatten von 0,1 bis 7, insbesondere 0,7 bis 6,5 mm.

Eine übliche Methode der Vorbehandlung ist die vollflächige Belichtung des Aufzeichnungsmaterials von der Rückseite her mit aktinischem Licht. Unter Rückseite ist hier diese Seite zu verstehen, welche der später gebildeten Reliefschicht abgewandt ist.

Geeignete Lichtquellen für aktinisches Licht sind handelsübliche UV-Fluoreszenzröhren, Quecksilbermittel-, -hoch- und -niederdruckstrahler, superaktinische Leuchtstoffröhren, Xenon-Impulslampen, mit Metalliodiden dotierte Lampen oder Kohlenbogenlampen.

Beispiele geeigneter organischer Entwickler sind aliphatische oder aromatische Kohlenwasserstoffe, wie n-Hexan, n-Heptan, Octan, Petrolether, Ligroin, Limonen oder andere Terpene, Toluol, Xylol, Ethylbenzol oder Isopropylbenzol oder Gemische aus diesen Lösemitteln; Ketone, wie Aceton oder Methylethylketon; Ether, wie Di-n-butylether; Ester, wie Essigsäureethylester, halogenierte aliphatische Kohlenwasserstoffe, wie Methylenchlorid, Chloroform, Trichlorethane, Tetrachlorethylen, Dichlortetrafluorethane oder Trichlortrifluorethane; oder Gemische, die zwei oder mehr dieser Lösemittel enthalten; oder Gemische die eines oder mehrere dieser Lösemittel und zusätzlich noch Alkohole, wie Methanol, Ethanol, Isopropanol oder n-Butanol enthalten; oder Lösemittel und Gemische der genannten Art, die zusätzlich feste, flüssige oder gasförmige organische und anorganische Verbindungen, wie etwa Tenside, in untergeordneten Mengen enthalten.

Übliche Methoden der Nachbehandlung der Reliefbilder oder Druckformen sind das vollflächige Nachbelichten mit aktinischem Licht einer Wellenlänge zwischen 150 und 450 nm oder das Behandeln mit halogenhaltigen Lösungen.

Werden die erfindungsgemäßen Aufzeichnungsmaterialien diesem Verfahren unterzogen, erweisen sie sich als
- rasch belichtbar, wobei ihr Belichtungsspielraum ausgesprochen groß ist,
- detailgetreu in der Wiedergabe auch der feinsten und daher kritischen Bildmotive der Bildmasken oder Negativvorlagen und als
- ausgesprochen auswaschstabil, so daß die Entwicklungsbedingungen zwecks Verkürzung der Entwicklungszeiten bedenkenlos verschärft werden können.

Dadurch verkürzen sich die Taktzeiten bei der Herstellung von Reliedruckplatten und Photoresists, was für die betriebliche Praxis ein erheblicher Vorteil ist. Dieser Vorteil fällt insbesondere bei der Herstellung von Flexodruckplatten ins Gewicht.

Die aus den erfindungsgemäßen Aufzeichnungsmaterialien erhaltenen Druckplatten zeigen während des Druckens auf einem üblichen und bekannten Flexodruckwerk eine ausgeprägte Stabilität gegenüber Druckfarben, die Ester und/oder Ketone enthalten sowie gegenüber durch UV-Strahlung härtbaren Druckfarben. Hinzu kommt noch daß die neuen Flexodruckplatten deutlich stabiler gegenüber Ozon sind als die Flexodruckplatten des Standes der Technik. Darüber hinaus können die neuen Flexodruckplatten mehrfach wiederverwendet werden, ohne daß die Qualität der Druckerzeugnisse hierbei leidet.

Die folgenden Beispiele beschreiben bevorzugte Ausführungsformen der Erfindung. Darin angegebene Teile, Mengenverhältnisse und Prozente sind, wenn nichts anderes gesagt wird, in Gewichtseinheiten zu verstehen.

### Beispiel 1

Eine Lösung aus

| | |
|---|---|
| 78 Teilen | eines Styrol-Ethylen/Butylen-Isopren-Styrol-Block-copolymeren mit 18% Styrol-, 36% Isopren - und 46% Ethylen/1,2-Butylen-Einheiten, (Kraton®G RP 6919) |
| 10 Teilen | Hexandioldiacrylat, |
| 5 Teilen | Paraffinöl (Weißöl S 5000), |
| 1 Teil | Benzildimethylketal und |
| 1 Teil | Di-t-butyl-p-kresol in |
| 150 Teilen | Toluol |

wurde durch Rühren bei 80°C hergestellt. Die Lösung wurde auf eine 125 µm dicke Polyethylenterephthalatfolie (Mylar®, du Pont de Nemours Co.) gegossen. Die Folie wurde zuvor mit einer ca. 5 µm dünnen Deckschicht aus Polyamid (Makromelt® 6900, Henkel KGa.A.) beschichtet. Die Lösung wurde bei 80°C auf die Folie aufgegossen und anschließend 2 h bei 60°C getrocknet. Anschließend wurde die Schicht über Nacht abgelüftet. Nach Trocknen und Ablüften betrug die Dicke der lichtempfindlichen Schicht 700 µm. Der Verbund aus Deckfolie, Deckschicht und lichtempfindlicher Schicht wurde anschließend durch Kaschieren mit einer mit Haftlack versehenen 125 µm dicken Trägerfolie aus Polyethylenterephthalat (Hostaphan® RN) verbunden.

Nach einer Lagerzeit von 1 Woche wurde aus der Druckplatte ein Klischee hergestellt. Folgende Verarbeitungsschritte wurden durchgeführt:
a) Abziehen der Schutzfolie,
b) Auflegen eines Testfilms nyloflex® FAR II, BASF)
c) stufenweise bildmäßige Hauptbelichtung unter Vakuumfolie (F III Belichter BASF, Belichtungszeiten von 2 bis 20 Minuten),
d) Auswaschen der Platte bis auf die Trägerfolie (Durchlaufsystem VF III BASF, Durchlaufzeit 150 mm/min, Auswaschmittel nylosolv® II von BASF, 30°C, Relieftiefe 700 µm),
e) 2 h Trocknen bei 65°C
f) Nachbelichtung (F III Belichter BASF, 10 Minuten)
g) Nachbehandeln mit UV-C-Licht (F III Nachbehandlungsgerät BASF, 10 Minuten)

Das hergestellte Klischee wurde beurteilt. Bestimmt wurde die Belichtungszeit, die notwendig ist, um die Testelemente korrekt auszubilden. Ferner wurde die Shore-A-Härte des Klischeematerials bestimmt. An den Vollflächen des Klischees wurden Quellungsmessungen vorgenommen. Hierzu wurde eine Vollfläche mit den Abmessungen 5 x 5 cm mit der Druckfarbe bestrichen. Nach einer Einwirkzeit von 24 Stunden wurde die Druckfarbe abgewischt und die Gewichtszunahme bestimmt. Als Druckfarben wurden eine durch UV-Belichtung nach einem radikalischen Mechanismus härtbare Druckfarbe (Magenta Y 1635 C, Zeller-Gmelin) und eine durch UV-Belichtung nach einem kationischen Mechanismus härtbare Druckfarbe (Magenta Q 1635 C, Zeller-Gmelin) verwendet. Die Ergebnisse sind in Tabelle 1 zusammengestellt.

### Beispiel 2

Eine Druckplatte wurde entsprechend Beispiel 1 hergestellt. Die Bestandteile der Lösung waren:

| | |
|---|---|
| 68 Teile | des in Beispiel 1 angegebenen Blockcopolymeren, |
| 10 Teile | Hexandioldiacrylat, |
| 10 Teile | Dihydrodicyclopentadienylacrylat, |
| 5 Teile | Weißöl S 5000, |
| 1 Teil | Benzildimethylketal und |
| 1 Teil | Di-t-butyl-p-kresol in |
| 150 Teilen | Toluol |

Die Druckplatte wurde wie in Beispiel 1 zum Klischee verarbeitet und beurteilt.

### Beispiel V3

### (Vergleichsbeispiel)

Eine Druckplatte wurde entsprechend Beispiel 1 hergestellt. An Stelle des dort eingesetzten Block-Copolymeren wurde ein handelsübliches Styrol-Isopren-Styrol-Dreiblockcopolymere (Kraton® D 1161, Shell) mit einem Styrolanteil von 15% und einem Isoprenanteil von 85% eingesetzt. Die Druckplatte wurde wie in Beispiel 1 zum Klischee verarbeitet und beurteilt.

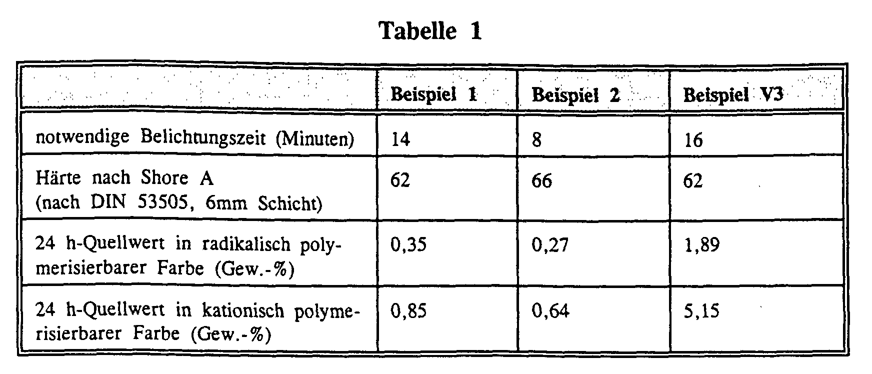

Man ersieht aus Tabelle 1, daß sich die erfindungsgemäßen Aufzeichnungmaterialien durch eine kurze Belichtungszeit (das bedeutet ein hohes Auflösungsvermögen), eine für Flexoplatten typische geringe Härte und niedrige Quellwerte auszeichnen. Die Vorteile der erfindungsemäßen Aufzeichnungsmaterialien zeigten sich auch in einem vergleichend durchgeführten Druckversuch mit der kationisch härtenden Druckfarbe. Hierzu wurden die Druckplatten auf einen Druckzylinder aufgespannt und auf einem üblichen Flexodruckwerk verdruckt. Der Bedruckstoff war eine Polyethylenfolie. Die Druckgeschwindigkeit betrug 120 m/Minute. Während die erfindungsgemäßen Druckplatten über eine Druckdauer von 1 Stunde ein hervorragendes, gleichbleibendes Druckergebnis lieferten, änderte sich das Druckbild der Vergleichsplatte bereits nach 15 Minuten Druckdauer. Insbesondere die Rasterpartien druckten mit zunehmender Druckdauer stärker aus, was auf eine unzureichende Quellbeständigkeit des Materials zurückgeführt werden kann.

## Patentansprüche

1. Lichtempfindliches Gemisch, das
A) ein elastomeres Block-Copolymeres als Bindemittel,
B) eine polymerisierbare Verbindung und
C) eine Verbindung enthält, die unter Einwirkung aktinischer Strahlung die Polymerisation der Verbindung B zu initiieren vermag,
**dadurch gekennzeichnet, daß** das elastomere Block-Copolymere A ein Copolymeres mit Blöcken aus polymerisierten
1. Styroleinheiten
2. Ethylen- und 1,2-Butyleneinheiten als Alkyleneinheiten und
3. Isopreneinheiten als Dieneinheiten,
herstellbar durch Hydrierung von Blockcopolymeren mit Blöcken aus Styroleinheiten, Isopreneinheiten und Butadieneinheiten,
ist.

2. Lichtempfindliches Gemisch nach Anspruch 1, **dadurch gekennzeichnet, daß** das zu hydrierende Block-Copolymere aus Styrol-, Butadien- und Isoprenblöcken durch Verknüpfen von vorgefertigten Isoprenblöcken mit vorgefertigten Block-Copolymeren aus einem Styrol- und einem Butadienblock mittels mehrfunktioneller Kupplungsagentien hergestellt ist.

3. Lichtempfindliches Gemisch nach Anspruch 1 oder 2, **dadurch gekennzeichnet, daß** das elastomere Block-Copolymere A 10 bis 40 Gew.-% Styrolblöcke, 10 bis 70 Gew.-% Alkylenblöcke und 10 bis 60 Gew.-% Dienblöcke enthält.

4. Lichtempfindliches Gemisch nach einem der Ansprüche 1 bis 3, **dadurch gekennzeichnet, daß** es 50 bis 95 Gew.-% Bindemittel A, 5 bis 50 Gew.-% polymerisierbare Verbindungen B und 0,1 bis 5 Gew.-% Photoinitiatoren C, bezogen auf die Gesamtmenge von A + B, enthält.

5. Lichtempfindliches Aufzeichnungsmaterial mit einem dimensionsbeständigen Schichtträger und einer darauf aufgebrachten lichtempfindlichen Schicht, **dadurch gekennzeichnet, daß** die lichtempfindliche Schicht,
A) ein elastomeres Block-Copolymeres als Bindemittel,
B) eine polymerisierbare Verbindung und
C) eine Verbindung enthält, die unter Einwirkung aktinischer Strahlung die Polymerisation der Verbindung B zu initiieren vermag,
**dadurch gekennzeichnet, daß** das elastomere Block-Copolymere A ein Block-Copolymeres mit Blöcken aus polymerisierten
1. Styroleinheiten,
2. Ethylen- und 1,2-Butyleneinheiten und
3. Isopreneinheiten,
herstellbar durch Hydrierung von Blockcopolymeren mit Blöcken aus Styroleinheiten, Isopreneinheiten und Butadieneinheiten,
ist.

6. Lichtempfindliches Aufzeichnungsmaterial nach Anspruch 5, **dadurch gekennzeichnet, daß** das zu hydrierende Block-Copolymere aus Styrol-, Butadien- und Isoprenblöcken durch Verknüpfen von vorgefertigten Isoprenblöcken mit vorgefertigten Block-Copolymeren aus einem Styrol- und einem Butadienblock mittels mehrfunktioneller Kupplungsagentien hergestellt ist.

7. Lichtempfindliches Aufzeichnungsmaterial nach Anspruch 5 oder 6, **dadurch gekennzeichnet, daß** es auf der lichtempfindlichen Schicht eine transparente, nicht klebrige Deckschicht trägt.

8. Lichtempfindliches Aufzeichnungsmaterial nach einem der Ansprüche 5 bis 7, **dadurch gekennzeichnet, daß** es auf der obersten Schicht eine abziehbare Deckfolie trägt.

9. Verfahren zum Herstellen von Reliefbildern oder Reliefdruckformen, **dadurch gekennzeichnet, daß** man ein lichtempfindliches Aufzeichnungsmaterial nach einem der Ansprüche 5 bis 8 bildmäßig mit aktinischem Licht belichtet und, gegebenenfalls nach Abziehen der Deckfolie, durch Auswaschen der unbelichteten Schichtbereiche mit einem Entwickler entwickelt.

10. Verfahren zum Bedrucken von Bedruckstoffen mittels einer Reliefdruckform, bei dem man die Bildbereiche einer flexographischen Reliefdruckform, die nach dem Verfahren von Anspruch 9 hergestellt worden ist, mit einer Druckfarbe einfärbt, die Ester enthaltende Lösemittel oder durch UV-Strahlung härtbare Verbindungen enthält, die Druckfarbe auf den Bedruckstoff überträgt und das Druckbild durch Verdampfen des Lösemittels trocknet oder durch Bestrahlen mit UV-Strahlung härtet.

## Claims

1. A photosensitive mixture which contains
A) an elastomeric block copolymer as a binder,
B) a polymerizable compound and
C) a compound capable of initiating the polymerization of the compound B under the action of actinic radiation,
wherein the elastomeric block copolymer A is a copolymer having blocks of polymerized
1. styrene units,
2. ethylene and 1,2-butylene units as alkylene units and
3. isoprene units as diene units,
which can be prepared by hydrogenating block copolymers having blocks comprising styrene units, isoprene units and butadiene units.

2. A photosensitive mixture as claimed in claim 1, wherein the block copolymer to be hydrogenated is prepared from styrene, butadiene and isoprene blocks by linking prepared isoprene blocks with prepared block copolymers comprising a styrene block and a butadiene block by means of polyfunctional coupling agents.

3. A photosensitive mixture as claimed in claim 1 or 2, wherein the elastomeric block copolymer A contains from 10 to 40% by weight of styrene blocks, from 10 to 70% by weight of alkylene blocks and from 10 to 60% by weight of diene blocks.

4. A photosensitive mixture as claimed in any of claims 1 to 3, which contains from 50 to 95% by weight of binder A, from 5 to 50% by weight of polymerizable compounds B and from 0.1 to 5% by weight of photoinitiators C, based on the total amount of A + B.

5. A photosensitive recording material having a dimensionally stable substrate and a photosensitive layer applied thereon, wherein the photosensitive layer contains
A) an elastomeric block copolymer as a binder,
B) a polymerizable compound and
C) a compound capable of initiating the polymerization of the compound B under the action of actinic radiation,
wherein the elastomeric block copolymer A is a block copolymer having blocks of polymerized
1. styrene units,
2. ethylene and 1,2-butylene units and
3. isoprene units,
which can be prepared by hydrogenating block copolymers having blocks comprising styrene units, isoprene units and butadiene units.

6. A photosensitive recording material as claimed in claim 5, wherein the block copolymer to be hydrogenated is prepared from styrene, butadiene and isoprene blocks by linking prepared isoprene blocks with prepared block copolymers comprising a styrene block and a butadiene block by means of polyfunctional coupling agents.

7. A photosensitive recording material as claimed in claim 5 or 6, which carries a transparent, nontacky release layer on the photosensitive layer.

8. A photosensitive recording material as claimed in any of claims 5 to 7, which carries a removable cover sheet on the uppermost layer.

9. A process for the production of relief images or relief printing plates, wherein a photosensitive recording material as claimed in any of claims 5 to 8 is exposed imagewise to actinic light and, if necessary after removal of the cover sheet, is developed by washing out the unexposed parts of the layer with a developer.

10. A method for printing of printing materials by means of a relief printing plate, in which the image parts of a flexographic relief printing plate which has been produced by the process of claim 9 are inked with a printing ink which contains ester-containing solvents or UV-curable compounds, the printing ink is transferred to the printing material and the printed image is dried by evaporating the solvent or cured by exposure to UV radiation.

## Revendications

1. Mélange photosensible comprenant
A) en tant que liant, un copolymère séquencé élastomère,
B) un composé polymérisable, et
c) un composé capable d'amorcer la polymérisation du composé B sous l'effet d'un rayonnement actinique,
**caractérisé en ce que** le copolymère séquencé A est un copolymère constitué de séquences de
1) motifs de styrène
2) motifs d'éthylène et de 1,2-butylène, en tant que motifs d'alkylène, et de
3) motifs d'isoprène, en tant que motifs diène, polymérisés, que l'on peut produire au moyen de l'hydrogénation de copolymères séquencés contenant des séquences de motifs de styrène, d'isoprène et de butadiène.

2. Mélange photosensible selon la revendication 1, **caractérisé en ce que** l'on fabrique le copolymère séquencé à hydrogéner, composé de séquences de styrène, de butadiène et d'isoprène, en liant des séquences d'isoprène préfabriquées avec des copolymères séquencés préfabriqués, composés d'une séquence de styrène et de butadiène, au moyen d'agents de liaison plurifonctionnels.

3. Mélange photosensible selon la revendication 1 ou 2, **caractérisé en ce que** le copolymère séquencé élastomère A contient de 10% à 40% en poids de séquences de styrène, de 10% à 70% en poids de séquences d'alkylène et de 10% à 60% en poids de séquences de diène.

4. Mélange photosensible selon l'une quelconque des revendications 1 à 3, **caractérisé en ce qu'**il contient de 50% à 95% en poids de liant A, de 5% à 50% en poids de composé polymérisable B et de 0,1% à 5% en poids de photoamorceur C, par rapport à la quantité totale de A + B.

5. Matériau d'enregistrement photosensible contenant un support de dimension stable, sur lequel on a appliqué une couche photosensible, **caractérisé en ce que** la couche sensible comprend
A) en tant que liant, un copolymère séquencé élastomère,
B) un composé polymérisable, et
C) un composé capable d'amorcer la polymérisation du composé B sous l'effet d'un rayonnement actinique
**caractérisé en ce que** le copolymère séquencé élastomère A est un copolymère contenant des séquences de
1) motifs de styrène
2) motifs d'éthylène et de 1,2-butylène et
3) motifs d'isoprène,
polymérisés, que l'on peut produire au moyen de l'hydrogénation de copolymères séquencés constitués des séquences de motifs de styrène, d'isoprène et de butadiène.

6. Matériau d'enregistrement photosensible selon la revendication 5, **caractérisé en ce que** l'on fabrique le copolymère séquencé à hydrogéner, constitué de séquences de styrène, de butadiène et d'isoprène, en liant des séquences d'isoprène préfabriquées avec des copolymères séquencés préfabriqués, composés d'une séquence de styrène et d'une séquence de butadiène, au moyen d'agents de liaison plurifonctionnels.

7. Matériau d'enregistrement photosensible selon la revendication 5 ou 6, **caractérisé en ce qu'**il porte, sur sa couche photosensible, une couche de protection transparente non collante.

8. Matériau d'enregistrement photosensible selon l'une quelconque des revendications 5 à 7, **caractérisé en ce qu'**il porte, sur sa couche supérieure, une feuille de protection détachable.

9. Procédé de fabrication d'images en relief ou de formes imprimées en relief, **caractérisé en ce que** l'on expose un matériau d'enregistrement photosensible selon l'une quelconque des revendications 5 à 8, selon une image à une lumière actinique et **en ce qu'**on le développe, éventuellement après avoir retiré la feuille de protection, en lavant les parties de la couche non exposées avec un révélateur.

10. Procédé d'impression de matière d'impression au moyen d'une forme imprimée en relief, selon lequel on colore les parties d'image d'une forme flexographique imprimée en relief, fabriquée selon le procédé de la revendication 9, avec une encre d'imprimerie, comprenant des solvants contenant des esters ou des composés durcissables par rayonnement UV, on transfère l'encre d'imprimerie sur la matière d'impression et on sèche l'image imprimée en évaporant le solvant ou on la durcit en l'exposant à un rayonnement UV.
